# EUROPEAN PATENT APPLICATION

(11) **EP 2 429 075 A1**
(43) Date of publication of application: **14.03.2012**
(21) Application number: 11151672.0
(22) Date of filing: 21.01.2011
(51) Int. Cl.: H03F 1/22, H03F 3/217, H03F 3/24, H03F 3/45, H03F 3/72

(54) **Amplifier circuit for a ranging transceiver**

(30) Priority: 13.09.2010 US 201061382379 P
(71) Applicant: IMEC, 3001 Leuven (BE); Universiteit Gent, 9000 Gent (BE)
(72) Inventor: Bauwelinck, Johan, 9140 Temse (BE); Li, Zhisheng, 9000 Gent (BE); Torfs, Guy, 9000 Gent (BE); Vandewege, Jan, 9030 Mariakerke-Gent (BE); Yin, Xin, 9000 Gent (BE)
(74) Representative: Van Bladel, Marc

(57) **Abstract**

The present invention is related to an amplifier circuit for modulating an input signal in a ranging application comprising
- an input for applying an input signal,
- amplification means for amplifying the input signal, said amplification means comprising a first transistor (M1) arranged for receiving the input signal and a second transistor (M2) arranged in cascode with the first transistor,
- a switching means (Sw1) switchably connected between a gate of the second transistor (M2) on one side and a first and a second port for applying a first and second reference voltage signal on the other side, said first and second reference voltage signal being different and so selected that the amplification means has an amplification factor switchable between a first and a second amplification level to modulate the input signal applied to the amplification means,
- an output in connection with the amplification means for outputting the modulated input signal.

## Description

### Field of the Invention

The present invention generally relates to an amplifier circuit for use in a ranging transceiver, in particular for a transceiver arranged for performing indoor ranging.

### Background of the Invention

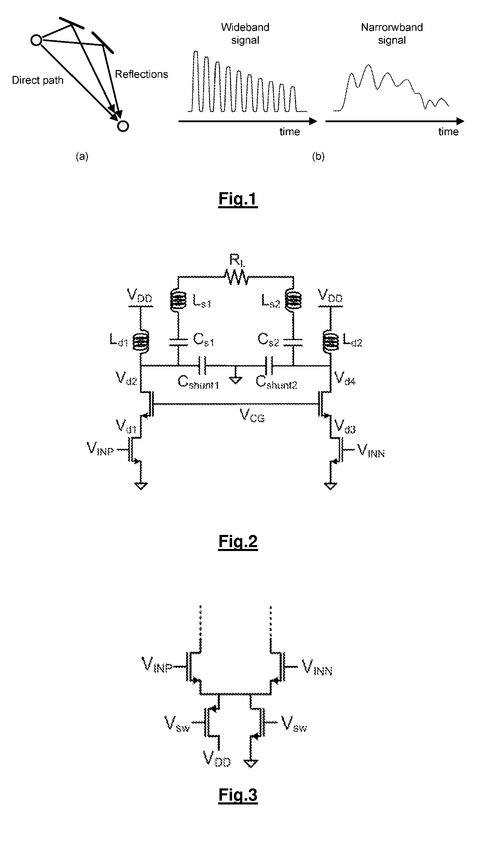

Ranging is the process of determining the distance from one location or position to another location or position. For indoor ranging with submeter accuracy wideband signals are required to avoid that multipath interference disturbs the time of arrival measurement, as illustrated in Fig.1.

A prior art ranging system is described in W02007/071748. The proposed indoor ranging system combines the advantages of both broadband and narrowband signals to achieve a high ranging accuracy in presence of strong multipath reflections, to realize a good link budget and to be compliant with the spectral regulations. The fundamental idea is that also relatively narrowband radios, such as those used in WLAN products, exhibit and/or can be stimulated to generate wideband transient signals at the beginning of the packet. A possible way to realize a fast enabling of the packet is to use an RF switch as proposed in the papers "Embedded ranging system in ISM Band" (X.Yin et al., Electronics Letters, vol. 44, no. 17, pp. 1043-1045, Aug. 2008) or "A Novel Positioning Technique for 2.4GHz ISM Band", (H. Tubbax, Proc. 4th IEEE Radio and Wireless Symposium, San Diego, USA, Jan. 2009). The wideband transient signals can then be leveraged for improved positioning accuracy at the receiver, by processing these wideband transient signals rather than just the narrowband communication signal. The system uses the same frequency band for both communication and ranging purposes, so that no separate dedicated ranging transceiver is needed. However, in order to achieve low cost and low power consumption an integrated ranging transceiver is needed.

Power amplifier circuits for ranging applications are often designed employing cascoded transistors. The advantages of a cascode topology have been analysed in detail in the literature, see for example the papers "A Common-Gate Switched 0.9- W Class-E Power Amplifier with 41% PAE in 0.25µm CMOS" (C.Yoo et al., IEEE J. Solid-state Circuits, vol.36, no.5, pp. 823-830, May 2001) and "Analysis of Reliability and Power Efficiency in Cascode Class-E PAs" (Mazzanti et al., IEEE J. of Solid-state Circuits, vol. 41, no. 5, pp. 1222-1229, May 2006). Although the maximum drain voltage can be 3.56 times the supply voltage ideally when no cascode is applied, the drain-source breakdown voltage is only 2 to 3 times the typical supply voltage for CMOS. When a cascode topology is used, the circuit can sustain two times the breakdown voltage of a single transistor, which thus can allow a maximum almost two times higher supply voltage. The same output power can be obtained with lower load resistance R_{L}, but the lower R_{L} gives rise to more power loss in the power amplifier, which degrades the efficiency.

Often a CMOS power amplifier is implemented as a class-E power amplifier. The class-E topology makes it possible to reuse the parasitic drain-source capacitance of the switching transistor. A class-E power amplifier circuit is typically used in a switching design for applications where power efficiency is a major issue and where such high frequencies are involved that the switching time becomes comparable to the duty time. Its operation is based on the portion of the input signal cycle during which the amplifying device conducts.

Advantageously, a differential topology is thereby adopted. The differential topology can provide a two times higher output power than the singleended one. For the same output power, the load resistance of a differential Class-E power amplifier (PA) can be two times higher than that of a single ended one, which thus can have higher efficiency. The topology of the differential cascode Class-E PA is shown in Fig.2.

Since a ranging Class-E power amplifier requires a very fast switch-on and switch-off speed for performing time-based ranging, a switching function should be added to the circuit. In "A 1.9-GHz, 1-W CMOS Class-E Power Amplifier for Wireless Communications" (Tsai and Gray, IEEE J. Solid-state Circuits, vol. 34, no. 7, pp. 962-970, July 1999) a common-source switch is applied at the common-source node of the input transistors (seen in Fig.3). No speed of the switch is mentioned. Since the common-source switch is on the signal path, which has a finite switch-on resistance, it inevitably degrades the drain efficiency of the power amplifier. In order to minimize the effect of the common-source switch, the size of the switch has to be huge, which costs a lot of area and thus is not efficient.

In order to control the output power for the class-E power amplifier most commonly the supply voltage is tuned. In case transformers are used to combine the output power of several power amplifiers, the power control can alternatively be implemented by switching on and off certain power amplifiers. Other solutions may consist in controlling the power by tuning the effective load resistance with varactors with high quality factor or by changing the size of the input transistor. Such techniques however offer a very limited power control range and low efficiency in low output power levels.

In "Output Power Control in Class-E Power Amplifiers" (Sira et al., IEEE Microwave and Wireless Components Let., vol. 20, no. 4, pp. 232-234, April 2010) the power control is implemented with dynamic cascode bias since a cascode topology is used. In "A 65 nm CMOS 30 dBm Class-E RF Power Amplifier With 60% PAE and 40% PAE at 16 dB Back-Off," (M. Apostolidou et al., IEEE J. of Solid-state Circuits, vol. 44, no. 5, May 2009) the power control is implemented with a dynamic supply voltage together with the dynamic self-bias voltage of the self-bias topology. However, with only dynamic drain supply and with only dynamic cascode bias the class-E PA cannot provide the optimal drain efficiency in low output power levels.

For the cascode Class-E topology it has been suggested to control the output power with the dynamic supply voltage. The cascode bias V_{CG} may be DC fixed or connected to V_{DD}. However, the optimal cascode bias shifts with the adjusting of V_{DD}. The lower V_{CG} is needed for the optimal drain efficiency when V_{DD} is lower. Hence, dynamic cascode bias is needed to optimize the output power and efficiency for different V_{DD} values. Implementing the power control by adjusting the cascode bias V_{CG} isn't a satisfactory solution either, as it also cannot provide the optimal efficiency in low output power levels.

### Aims of the invention

The present invention aims to provide a power amplifier circuit for use in a ranging application that overcomes the above-mentioned drawbacks of the prior art solutions.

### Summary

The present invention relates to an amplifier circuit for modulating an input signal in a ranging application. The amplifier circuit comprises
- an input for applying an input signal,
- amplification means for amplifying the input signal, whereby the amplification means comprises a first transistor arranged for receiving the input signal and a second transistor arranged in cascode with the first transistor,
- switching means switchably connected between a gate of the second transistor on one side and a first and, on the other side, a second reference voltage signal, respectively, said first and second reference voltage signal being different and so selected that the amplification means has an amplification factor switchable between a first and a second amplification level to modulate the input signal applied to the amplification means,
- an output in connection with the amplification means for outputting the modulated input signal.

The proposed solution indeed overcomes the drawbacks of the prior art. A common-gate switching means is provided outside the signal path between the input and output of the circuit. The switching means is so arranged that one can switch between two references voltages, each corresponding to a different amplification factor. The applied input signal is modulated by means of these two different amplification factors. In practice, the reference voltages and, consequently, the amplification levels are so chosen that the amplification means can be switched off and on, the reference voltage realizing the on switching is chosen to improve, if possible maximize, the efficiency of the amplification means. The switching means is designed to maximize the speed of changing between the reference voltages by maximizing its current flowing capabilities.

In a preferred embodiment the speed of switching between said first and second reference voltages is made adaptable by further providing in the amplifier circuit means for varying the current in the switching means or between the second transistor and the switching means. These means can for example be a resistive circuit.

Advantageously, the circuit comprises a means for setting a logical parameter for adapting the speed of switching. The logical parameter then sets the control logic of the switching means appropriately, so that one can choose between a slow switching mode and a fast switching mode.

In a preferred embodiment the amplification means is implemented as a class-E power amplifier. As already mentioned in the background section, a class-E power amplifier is very suitable for power amplification in applications where power efficiency is a major concern.

In one embodiment the first or said second reference voltage is determined according to a supply voltage of the class-E power amplifier. In one embodiment the first reference voltage is set at 0V to shut down the power amplifier. The second reference voltage is determined according to a supply voltage of the class-E power amplifier to maximize the power added efficiency.

In one embodiment the first and/or second reference voltage is realized with a resistive divider.

In a preferred embodiment the amplifier circuit further comprises a driver circuit for driving the class-E power amplifier.

In an embodiment of the amplifier circuit the driver circuit comprises a further amplification means for amplifying the input signal, said further amplification means comprising a third transistor arranged for receiving the input signal and a fourth transistor arranged in cascode with the third transistor, and further switching means connected between a gate of the fourth transistor on one side and a third and a fourth reference voltage on the other side, said third and fourth reference voltage being different and so selected that the amplification means has an amplification factor switchable between a given (high) amplification level and an off state to apply or remove a amplified version of the input signal applied to the amplification means, and an output for outputting a signal acting as input signal to said amplification means.

Preferably the amplifier circuit is implemented as a differential circuit. A differential topology offers the advantage that a higher output power can be provided.

The invention also relates to a transmitter/receiver device (i.e. a transceiver) comprising a transmitter having an amplifier circuit as previously described.

In an advantageous embodiment the transmitter of the transmitter/receiver part comprises a matching element for matching a capacitive impedance, whereby said matching element is further operable in the receiver part of the transmitter/receiver device.

In a preferred embodiment the receiver of the transmitter/receiver device comprises baseband filtering means implemented as a source follower based filter whereby the bulk and the gate of at least one transistor in the source follower based filter are connected.

Alternatively, the receiver of the transmitter/receiver device comprises baseband filtering means implemented as a source follower based filter whereby a cross-coupled transistor pair is added to an intermediate node of the source follower based filter.

### Brief Description of the Drawings

Presently preferred embodiments are described below in conjunction with the appended drawing figures, wherein like reference numerals refer to like elements in the various figures.

Fig. 1 illustrates (a) transmission over fading multipath channels, (b) received wideband and narrowband signal in dense multipath environments.

Fig. 2 shows a differential cascode Class-E PA (prior art).

Fig. 3 illustrates a common-source switch topology of a power amplifier (prior art).

Fig.4 illustrates an embodiment of the amplifier circuit according to the invention.

Fig. 5 illustrates the common-gate switch topology according to the invention.

Fig. 6 represents the output power and the drain efficiency as a function of the width of the switches.

Fig. 7 illustrates a schematic of the switch (a) and a possible implementation of the control logic (b).

Fig. 8 illustrates a resistive divider.

Fig. 9 illustrates a topology of a differential cascode class-E power amplifier with driver stages.

Fig. 10 illustrates drain efficiency as a function of output power with different power control methods.

Fig. 11 illustrates waveforms of nodes in the left part of the class-E stage.

Fig. 12 illustrates a transceiver without transmit/receive switch.

Fig. 13 illustrates (a) a source follower based filter circuit and (b) a differential source follower.

Fig. 14 illustrates (a) the integration of the body effect in the filter characteristic and (b) the linearization of the input stage, which is a source follower.

Fig. 15 illustrates the difference in OIP3 between a prior art solution and the solution of the invention.

### Detailed Description of the Invention

The invention presents a power amplifier circuit that can advantageously be used in a ranging application. The present disclosure also relates to a low cost, low power integrated (ranging) transceiver arranged for accurate indoor ranging. With ranging is meant estimating the distance between a transmitter and a receiver or, more in general, between a transmitter and several receivers. The transceiver comprises a transmitter (path) and a receiver (path). The transmitter comprises a power amplifier having the disclosed amplifier circuit arranged for fast switching of the packet envelope on a nanosecond scale. Fast switching is provided by adding a switching control block/switching function. The proposed amplifier circuit that optionally can be integrated in the transmitter part of a transceiver device further comprises a power control block arranged for controlling the output power of the power amplifier. The receiver part of the transceiver comprises baseband filters with high linearity due to the application of feedback around the input transistors and due to the special configuration that uses the body effect of the transistors advantageously.

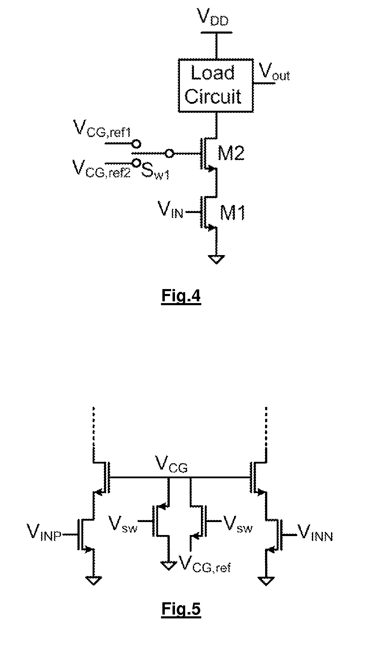

Fig. 4 illustrates the amplifier circuit according to an embodiment of the invention. An input V_{IN} is provided for applying an input signal. The input signal is applied to a first transistor M1 via its gate. A second transistor M2 is arranged in cascode with the first transistor. The two transistors constitute an amplification means (an amplifier). A switching means Sw1 is positioned between the gate of the second transistor M2 and on the other side a first and a second port for applying a first and second reference voltage (V_{CG,ref1} and V_{CG,ref2}). The two reference voltages are different and are so selected that the amplification means has an amplification factor switchable between a first and a second amplification level to modulate the input signal applied to the amplification means. At the output Vₒᵤₜ of the amplification means one then obtains a shaped (i.e. modulated) version of the input signal.

In an embodiment the power amplifier is a class E power amplifier. These amplifiers comprise (one or more) cascode transistors to extend the power supply voltage range. A switching function is placed at the common-gate node of the (plurality of) cascode transistors. Further, the power control block is arranged controlling the output power with a dynamic supply voltage and the cascode transistors' gate voltages.

Although other amplification means can be used as previously mentioned, the rest of the description will be given using a Class-E power amplifier as an example.

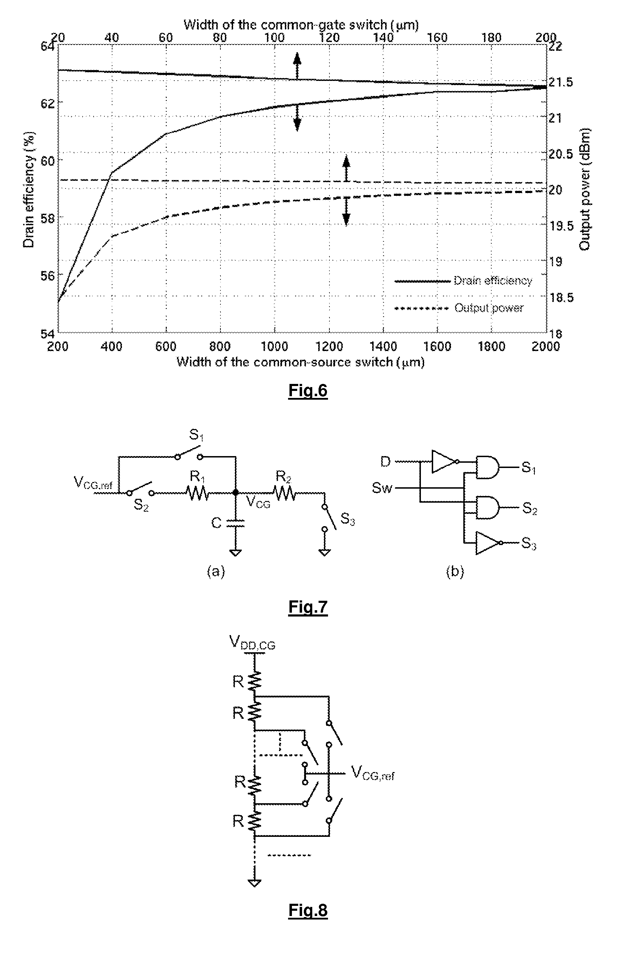

In a ranging application the switch function added to the Class-E power amplifier should perform on/off switching at high speed : the turn-on time of the output signal has to be less than 2 ns. In this invention this is achieved by a common-gate switch topology, which is placed at the common-gate node of the cascode transistors of the class-E power amplifier. Fig.5 represents an illustration. The minimum width of the switch required to meet the specification (of less than 2ns) is about 20 µm for the common-gate switch and at least 400 µm for the common-source switch (simulated in a 0.18um CMOS technology). The common-gate switch can provide a much higher switching speed with a much smaller switch size, which is much more efficient. As the proposed common-gate switch is not on the signal path, the efficiency of the power amplifier (PA) is not affected. The output power and drain efficiency as a function of the width of the switch are shown in Fig.6. As shown in Fig.6, both the output power and the drain efficiency of the PA with common-gate switch are higher than those of the power amplifier with the common-source switch, especially when the width of the common-source switch is not large enough. The output power and drain efficiency keep almost constant with the change of the width of the common-gate switch, which means the power amplifier performance is not affected by the common-gate switch.

Since the rise/fall time of the switch signal needs to be tunable, the circuit needs to have both fast-switching ability and slow-switching ability. Fig.7(a) shows the schematic of the switch and Fig.7(b) shows the control logic of the switch. In Fig.7(a) C is the effective capacitance at the common-gate node and R₁ and R₂ are the series resistors to control the rise/fall time of the switch.

In Fig.7 S₁, S₂ and S₃ are all high logic effective. D is used to choose for fast-switching mode or slow-switching mode. When D is 1, the circuit is in slow-switching mode. When D is 0, the circuit is in fast-switching mode. S_{w} is the switch signal to switch the PA on and off. V_{CG,ref} is the common gate voltage generated from the resistive divider in Fig.8. The output of the switch V_{CG} is connected to the common-gate node of the core circuit in Fig.2.

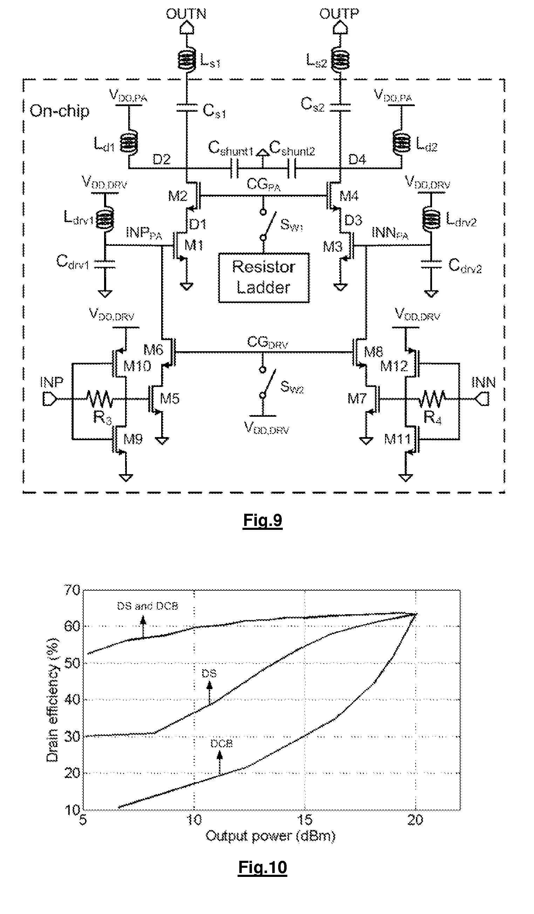

The proposed circuit is in one embodiment designed in a Silterra 0.18 µm RF CMOS process for the 2.4 GHz ISM band. The circuit of the proposed Class-E PA, shown in Fig.9, consists of two inverters with resistive feedback (M9, M10, M11, M12, R₃, R₄) as the first driver stage, a differential LC tank-loaded cascode amplifier (M5, M6, M7, M8, L_{drv1}, L_{drv2}, C_{drv1}, C_{drv2}) as the second driver stage and a differential cascode Class-E amplifier (M1, M2, M3, M4, L_{d1}, L_{d2}, Cₛₕᵤₙₜ₁, Cₛₕᵤₙₜ₂, Lₛ₁, Lₛ₂, Cₛ₁, Cₛ₂) as the output stage. Two switches S_{w1} (shown in Fig.7(a)) and S_{w2} (shown in Fig.5) are connected to the common-gate nodes of the output stage and the second driver stage to provide the fast switching. A resistive divider (shown in Fig.8) is added after S_{w1} (and named resistor ladder in Fig.9) to provide the dynamic cascode bias voltage. The load resistance R_{L} is 100 Ohm in differential.

In the Class-E stage the DC-feed inductors L_{d1} and L_{d2} are implemented with customized on-chip inductors for monolithic integration. When designing the inductors, both the Q factor and the area of the inductors have to be taken into account. The optimized differential drain inductance is 3.7 nH with a Q factor of 13 at 2.45GHz. Lₛ₁ and Lₛ₂ are implemented partly with bondwire inductances and partly with off-chip inductances. The effective inductance of Lₛ₁ and Lₛ₂ is 3 nH in the simulation.

The thin-oxide transistors are used for both the input and cascode transistors of the Class-E stage to minimize the switch-on resistances and the parasitic capacitances. Since in the cascode circuit the main voltage stress is the voltage stress of the cascode transistor, it is always safe to use thin-oxide transistors for the input transistors. However, care should be taken of the voltage limitations of the cascode transistors.

Due to the large parasitic capacitance at the input of the Class-E stage (typically more than 1 pF), a driver before the Class-E circuit is needed, which is implemented with a LC tank-loaded cascode amplifier to minimize the power consumption of the driver stage. With the cascode topology, higher supply voltages are allowed for larger output voltage swing. The supply of the driver stages is 2.0 V in this example. Customized on-chip differential inductors are used in this driver stage. The simulated differential inductance is 2.5 nH with a Q factor of 9.5.

The circuit should also have a good isolation (suppression of the output power when the PA is off) to avoid that nearby receivers detect the RF signal before the ranging edge. A switch is placed at the common-gate node CG_{DRV}, which provides better isolation between the switch-on and switch-off state. This is because when the driver stage is switched off, there would be no input signal at the input of the Class-E stage and then the output of the Class-E PA is clean.

An extra driver stage is applied to provide enough power gain, but another LC tank-loaded driver would cost a lot of area, even though some power will be saved. Two inverters with resistive feedback are adopted as the first driver stage in the disclosure.

The proposed power control method is implemented with the dynamic supply voltage together with the dynamic cascode bias. More specifically, the invention adopts dynamic drain supply voltage together with dynamic cascode bias for the power control of the power amplifier, which has a very wide power control range and very high drain efficiency in low output power levels. Because of the finite resistance of the dynamic cascode bias generator, the voltage stress is relieved and the efficiency is enhanced.

The simulated drain efficiency as a function of output power for different power control methods which are dynamic supply together with dynamic cascode bias (DS and DCB), dynamic supply only (DS) and dynamic cascode bias only (DCB) is shown in Fig.10. For the DS method and DCB method, the drain efficiency is optimized for maximum output power.

As shown in Fig.10, the drain efficiency for the dynamic supply together with dynamic cascode bias is improved a lot as compared with the other two control techniques especially for low output power levels.

The dynamic cascode biases V_{CG} are optimized for each V_{DD} by simulations, and implemented by adjusting the ratio of a resistive divider, shown in Fig.8.

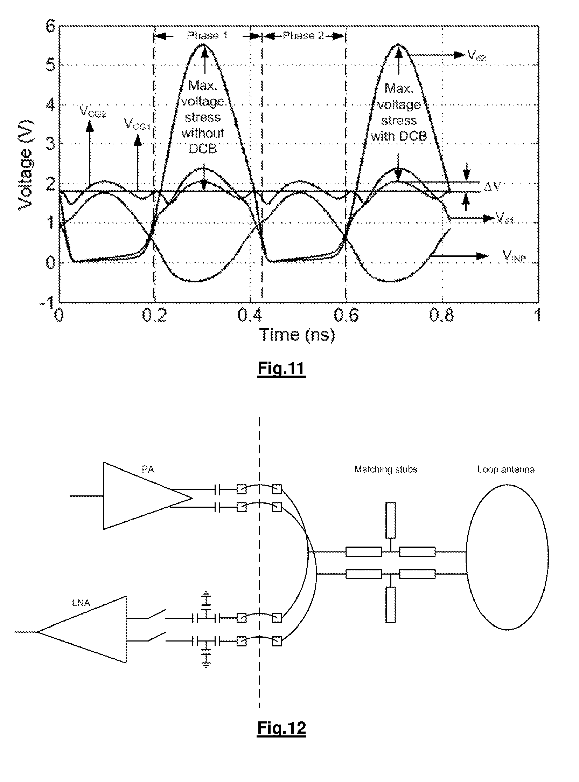

Since the resistive divider has a finite resistance, the voltage at V_{CG} is not fixed but has a ripple feeding through from the drains of the cascode transistors, the frequency of which is twice the working frequency due to the differential topology. The efficiency is enhanced and the voltage stress of the cascode transistors is relieved with the ripple. The simulated waveforms at different nodes of the left part of the Class-E stage in Fig.2 are shown in Fig.11, in which V_{CG1} and V_{CG2} represent the waveforms at V_{CG} with a fixed DC voltage and with dynamic cascode bias, respectively.

As shown in Fig.11, the input and cascode transistors turn off in phase 1 and turn on in phase 2 respectively. ΔV represents the maximum difference between V_{CG2} and V_{CG1} which is 0.25V both in phase 1 and phase 2 in the simulation. For the cascode topology, the main voltage stress is from the cascode transistor. When the circuit operates in phase 1, ΔV means that the drain-gate voltage stress of the cascode transistor is relieved by 0.25V with the dynamic cascode bias.

The amplifier circuit as previously described is in a preferred embodiment part of the transmitter of a transceiver device, i.e. a device capable of operating as a transmitter or a receiver. The transmitter and receiver then operate in half duplex mode. Typically, a transmit/receive switch is used to connect the transceiver to the antenna and to select the mode of operation (transmission or reception). This transmit/receive switch however introduces losses in the signal path (decreasing the transmit power and power efficiency and increasing the receiver noise figure) and distortion due to its non-linearity. As a consequence, a transceiver concept without transmit/receive switch is very useful for any wireless system.

The proposed transmitter integrated in a transceiver device has the following advantages:
- Fast enabling of the packet, which can be realized by a fast switching of the transmit power amplifier.
- Low-power, realized through an innovative power control scheme in the power amplifier (preserving a high efficiency also at low transmit powers), a transceiver concept without a transmit/receive switch, and optionally also a favourable circuit topology in the receive baseband filters.
- High bandwidth in the receive path, which requires special care for the linearity and baseband filtering as using a higher bandwidth reduces the frequency spacing to potential interferers.

In receive mode the cascode transistor of the power amplifier is also switched off, which allows a transceiver concept without transmit/receive switch towards the antenna, avoiding the loss, intermodulation or the need for an external component (a switch in the receive path is still needed, though it should not be able to handle high powers, making it easy to integrate on chip). The interconnection of the power amplifier and the low noise amplifier towards the same antenna is illustrated in Fig.12. Moreover, in receive mode, the power amplifier drain inductor remains connected to the output pins, helping the matching of the capacitive low noise amplifier.

A further improvement to the receiver design is possible in the filtering section, where a low-power high-linearity filter can be applied.

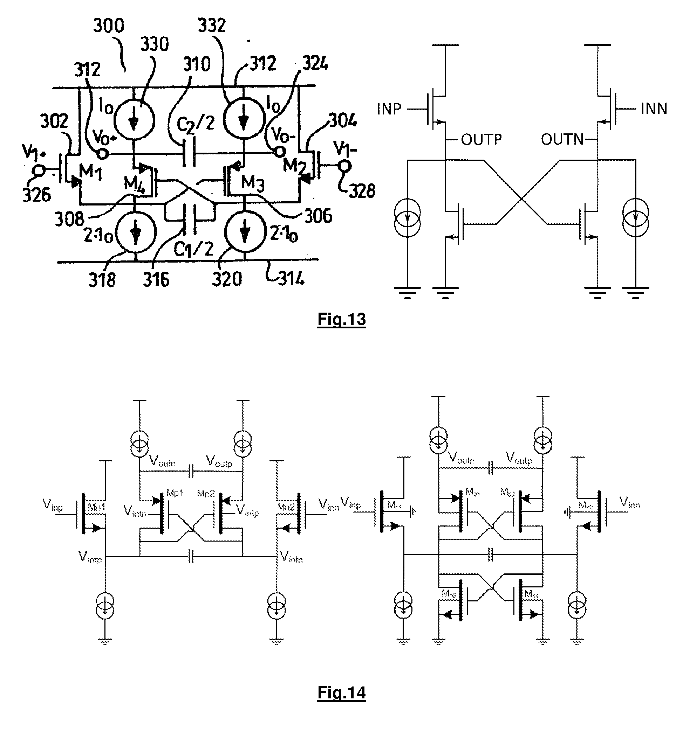

The receiver employs a direct conversion architecture. Due to the high bandwidth requirements, the baseband filters should be steep and highly linear to avoid intermodulation as the interferers are close to the pass band. For example, in an implementation of a 2.4GHz ranging transceiver (with tunable RF bandwidth from 250 to 400 MHz), nearby 2.2GHz UMTS transmitters pose very high challenges to the integrated active baseband filters. Several low-power topologies are known in the art. Here an improved structure is proposed as illustrated in the scheme of Fig.14(b). Through the linearization, less current is required in the input source follower, without degrading the noise and linearity of the filter section. Integration of the body effect in the filter characteristic further improves the linearity. Due to the body bias, the saturation voltage of the cross coupled transistors lowers (so that the saturation voltage of the current sources can be higher, which is better for the linearity) and a higher transconductance is obtained in the cross-coupled transistors so that a lower current is needed for the same transconductance. As a consequence, a low power consumption is achieved in a new innovative filter topology.

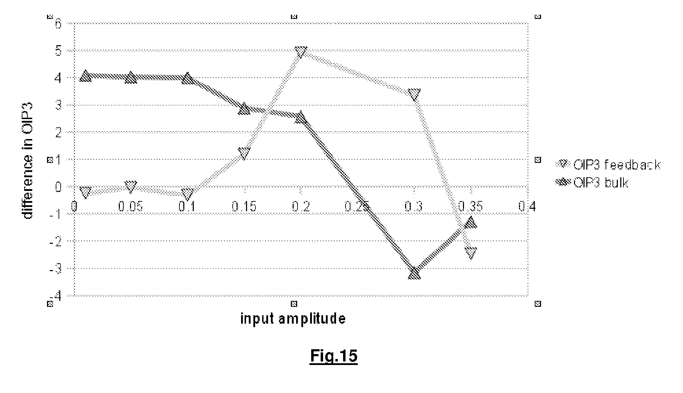

To show the advantages of both topologies these are compared with the original one. The difference in OIP3 (output referred 3^{rd} order intercept point) point is shown in Fig.15. It can be seen that the body effect works up to 200mVpdiff input voltage. If the voltage increases the non-linearities of the forward biased bulk diode start to dominate. The linearization with feedback around the input source follower works comparable with the original design at low input amplitudes. The feedback starts to work when the input signal is large enough. From this point until the distortion becomes too large, the feedback improves the linearity.

The present disclosure is described with respect to particular embodiments and with reference to certain drawings but the disclosure is not limited thereto. The drawings described are only schematic and are non-limiting. In the drawings, the size of some of the elements may be exaggerated and not drawn on scale for illustrative purposes.
Furthermore, the terms first, second, third and the like in the description and in the claims, are used for distinguishing between similar elements and not necessarily for describing a sequential or chronological order. The terms are interchangeable under appropriate circumstances and the embodiments of the disclosure can operate in other sequences than described or illustrated herein.
Moreover, the terms top, bottom, over, under and the like in the description and the claims are used for descriptive purposes and not necessarily for describing relative positions. The terms so used are interchangeable under appropriate circumstances and the embodiments of the disclosure described herein can operate in other orientations than described or illustrated herein.
The term "comprising", used in the claims, should not be interpreted as being restricted to the means listed thereafter; it does not exclude other elements or steps. It needs to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting of only components A and B. It means that with respect to the present disclosure, the only relevant components of the device are A and B.

## Claims

1. An amplifier circuit for modulating an input signal in a ranging application comprising
- an input for applying an input signal,
- amplification means for amplifying said input signal, said amplification means comprising a first transistor (M1) arranged for receiving said input signal and a second transistor (M2) arranged in cascode with said first transistor,
- a switching means (Sw1) switchably connected between a gate of said second transistor on one side and a first and a second port for applying a first and second reference voltage, respectively, on the other side, said first and second reference voltage being different and so selected that said amplification means has an amplification factor switchable between a first and a second amplification level to modulate the input signal applied to the amplification means,
- an output in connection with said amplification means for outputting the modulated input signal.

2. Amplifier circuit as in claim 1, further comprising means for varying the current between said second transistor and said switching means or in said switching means, so that the speed of switching between said first and second reference voltages is adaptable.

3. Amplifier circuit as in claim 2, further comprising a means for setting a logical parameter for adapting said speed of switching.

4. Amplifier circuit as in any of claims 1 to 3, whereby said amplification means is implemented as a class-E power amplifier.

5. Amplifier circuit as in claim 4, wherein said first or said second reference voltage is determined according to a supply voltage of said class-E power amplifier.

6. Amplifier circuit as in claim 5, comprising a resistive divider.

7. Amplifier circuit as in any of claims 4 to 6, further comprising a driver circuit for driving said class-E power amplifier.

8. Amplifier circuit as in claim 7, whereby said driver circuit comprises a further amplification means for amplifying said input signal, said further amplification means comprising a third transistor (M5) arranged for receiving said input signal and a fourth transistor (M6) arranged in cascode with said third transistor, and further switching means (Sw2) switchably connected between a gate of said fourth transistor on one side and a third and a fourth reference voltage on the other side, said third and fourth reference voltage being different and so selected that said amplification means has an amplification factor switchable between a given amplification level and an off state to apply or remove an amplified version of said input signal applied to the amplification means, and an output for outputting a signal acting as input signal to said amplification means.

9. Amplifier circuit as in any of the previous claims, implemented as a differential circuit.

10. Transmitter/receiver device comprising a transmitter having an amplifier circuit as in any of the previous claims.

11. Transmitter/receiver device as in claim 10, wherein said transmitter comprises a matching element for matching a capacitive impedance, said matching element further being operable in the receiver part of said transmitter/receiver device.

12. Transmitter/receiver device as in claim 10 or 11, wherein said receiver comprises baseband filtering means implemented as a source follower based filter whereby the bulk and the gate of at least one transistor in said source follower based filter are connected.

13. Transmitter/receiver device as in claim 10 or 11, wherein said receiver comprises baseband filtering means implemented as a source follower based filter whereby a cross-coupled transistor pair is added to an intermediate node of the source follower based filter.
